# EUROPEAN PATENT APPLICATION

(11) **EP 3 300 122 A1**
(43) Date of publication of application: **28.03.2018**
(21) Application number: 16190415.6
(22) Date of filing: 23.09.2016
(51) Int. Cl.: H01L 31/0224, H01L 31/0232, H01L 31/0216

(54) **MATERIAL STRUCTURE FOR A SOLAR CELL AND A SOLAR CELL COMPRISING THE MATERIAL STRUCTURE**

(71) Applicant: INL - International Iberian Nanotechnology Laboratory, 4715-330 Braga (PT); Universidade do Minho, 4704-553 Braga (PT)
(72) Inventor: Salomé, Pedro, 3830-209 Ilhavo (PT); Sadewasser, Sascha, 4715-031 Braga (PT); Borme, Jerome Gilles Ollivier, 4710-409 Braga (PT); Machado Junior, George Luiz, 4710-435 Braga (PT); Alpuim, Joao Pedro dos Santos Hall de agorreta de, 4715-010 Braga (PT)
(74) Representative: Awapatent AB

(57) **Abstract**

A material structure (100) for a solar cell, the material structure comprising, a light absorbing layer (102, 202, 302), a metal layer (104, 204, 304), a graphene layer (106, 206, 306) arranged in between the light absorbing layer and the metal layer, such that the graphene layer forms an electrical interface between the light absorbing layer and the metal layer, wherein the metal layer comprises at least one of Cu and Mo. A solar cell comprising the material structure is also disclosed.

## Description

### Technical Field

The present invention relates to a material structure for a solar cell. A solar cell comprising the material structure is also disclosed.

### Background Art

A solar cell is a structure that converts solar energy into electrical energy. If an incoming photon has a suitable wavelength, the photon may be absorbed and excite an electron from a valence band to a conduction band in the semiconductor material, resulting in the creation of an electron-hole pair. A conventional solar cell often includes a p-n junction created between two adjacent semiconductor materials with different doping types. Due to a built-in electric field in the depletion region of the p-n junction, a minority carrier, e.g. an electron excited at the p-doped side of the junction, that enters the depletion region around the junction will drift across the junction and become a majority carrier on the other side, e.g. the n-doped side. The junction may therefore serve as a charge separator, and e.g. an electron crossing the junction may be prohibited to return back across the junction. If leads are connected to each side of the junction, e.g. by forming an ohmic metal-semiconductor contact, and joined by a load, an electron on the n-doped side may instead escape through a lead and back to the p-doped side where it may recombine again with a hole. By doing so, a current is formed in the leads and the solar cell may work to power the load.

In conventional thin-film solar cells, such as solar cells using a layered semiconductor structure of copper, indium, gallium and selenium (Cu(In, Ga)Se₂, or simply CIGS) as a light absorber, the rear side of the solar cell is often contacted using leads made from molybdenum, Mo. During formation of a layer of Mo on the CIGS-structure, or the formation of a CIGS-structure on Mo, selenium ions will move from the CIGS-structure to the Mo and form an intermediate layer of MoSe₂. The intermediate selenization of Mo, and the resulting Mo/MoSe₂/CIGS layer structure, may therefore improve the contacting properties between Mo and CIGS and create a nearly ohmic contact. The same is true also for other light absorbing structures, such as Cu₂ZnSn(S,Se₄) (CZTS), where an intermediate layer of MoSe₂, or e.g. MoS₂ if the light absorbing layer contains sulfur, S, is also formed.

Although Mo has empirically proven to be a good rear-contact candidate, the metal may be both expensive and have poor optical reflectivity in the range of visible light. In addition, a too thick MoSe₂ or MoS₂ intermediate layer may degrade the performance of the electrical contact. As an option to Mo, other metals or compounds have also been considered but often shown to be either fully selenized, or expensive and with poor optical reflectivity as well.

In light of the above, there is a need to provide a material structure for a solar cell that at least partially solves or mitigates the above problems.

### Summary of the Invention

An object of the present invention is therefore to provide an improvement of the above solar cell devices and prior art.

According to one aspect of the present invention, a material structure for a solar cell is provided. The material structure includes a light absorbing layer, a metal layer and a graphene layer arranged between the light absorbing layer and the metal layer, such that the graphene layer forms an electrical interface between the light absorbing layer and the metal layer, and wherein the metal layer comprises at least one of Cu and Mo.

By arranging the graphene layer between the light absorbing layer and the metal layer, an improved, i.e. a closer to ohmic, electrical contact between the latter two layers may be allowed. The graphene layer may block the diffusion of e.g. Se, or S from the layered semiconductor structure into Mo and Cu, and may thereby prevent the formation of e.g. an intermediate MoSe₂ or e.g. MoS₂ layer that may otherwise occur if Se and/or S are present in the light absorbing layer and the metallic layer comprises Cu or Mo. As a result, the issue with the risk of forming a too thick intermediate layer may at least be partially resolved as the graphene protects the metal layer against selenization or sulfurization when e.g. the light absorbing layer is formed on the metal layer. Likewise, the graphene layer may prohibit full selenization of a Cu or Mo. The graphene layer may also block migration of Cu or Mo from the metallic layer into the light absorbing layer, thus reducing the potential risk of degradation of solar cell performance.

If the metal layer e.g. comprises Cu, the growth of a copper selenide, e.g. CuSe, or other Cu-Se systems, layer during the formation of the light absorbing layer may be problematic due to a lattice mismatch. As a result, the copper selenide layer may fall off or otherwise separate from the underlying metal layer comprising Cu. By arranging the graphene layer in between, the formation of such a copper selenide layer may be prohibited.

The graphene layer may also increase the reflectivity of Cu and Mo in at least some part of the range of optical light. An increased portion of light may thus be reflected back into the light absorbing layer or out of the material structure, i.e. more light may be absorbed by the light absorbing layer and the efficiency of the solar cell may be improved. In addition, if the metal layer absorbs less light the performance of the structure may be improved as the metal layer may be heated to a lesser extent. Also, since more light may be absorbed by the light absorbing layer, the thickness of the light absorbing layer may be reduced without reduction of the amount of absorbed light. This may lead to lower production costs and thinner solar cells using the material structure.

Both Cu and Mo may be used as native substrates for growing graphene, using e.g. chemical vapor deposition, CVD, or other known methods for providing graphene layers. Using the same materials as both contacts and substrates for growing graphene may thus be advantageous in that e.g. fewer steps may be required in a process for fabrication of a solar cell, and in that more or less complicated transferring processes are not required in order to position the graphene on the metal layer.

A metal layer comprising more Cu than Mo, or only Cu, may be advantageous in that the conductivity of Cu may be several times that of Mo. As an example, the conductivity for Cu may be up to four times higher than for Mo. A metal layer of Cu may also be less expensive than Mo, thus reducing the cost of the metal layer materials. As an example, the price of Cu may be only one fourth of the price of Mo. In addition, the reflectivity in at least some part of the range of visible light may be increased for Cu compared to Mo, and the above mentioned benefits of higher reflectivity may be further increased.

In one embodiment of the present invention, the graphene layer may be disposed on top of the metal layer, and preferably directly on top of the metal layer if, for example, the metal layer is used as a native substrate (i.e. a catalyst layer) when growing the graphene layer.

In one embodiment of the present invention, the graphene layer may be a bilayer or multilayer graphene layer.

In one embodiment of the present invention, the light absorbing layer may comprise a compound semiconductor selected from the group of Cu(In, Ga)Se₂, Cu(In, Ga)(S, Se)₂, Cu₂ZnSn(S, Se)₄, and CdTe. Compared to conventional crystalline silicon, these compound semiconductors have higher absorption coefficients and absorb sunlight more efficiently. In addition, a much thinner film is required which may allow for increased flexibility and less cost.

In one embodiment of the present invention, the material structure may further include a substrate, wherein the metal layer is arranged on the substrate. The substrate may be rigid or flexible, and the substrate may be selected such that one or many parameters of the material structure are improved. In the same or other embodiments, the substrate may comprise at least one of glass, steel, metal foil, and a polymer.

In one embodiment of the present invention, the material structure may further include a buffer layer, where the buffer layer and the light absorbing layer form parts of a p-n junction arranged to convert light into an electric voltage. Efficient separation of charge carriers generated by the light absorbed by the material structure may thereby be obtained. The buffer layer may comprise at least one of CdS, Zn(O,S), In₂S₃, (Zn, Sn)O_{y,}and (Zn, Mg)O.

According to an additional aspect of the present invention, a solar cell may be provided that comprises a material structure as described above. In one embodiment of the present invention, such a solar cell may be a thin-film solar cell.

Further features of, and advantages with, the present invention will become apparent when studying the appended claims and the following detailed description. The skilled person will realize that different features of the present invention may be combined to create embodiments other than those described in the following, without departing from the scope of the present invention.

### Brief description of the drawings

This and other aspects of the present invention will now be described in more detail, with reference to the enclosed drawings in which:
Figure 1 a illustrates a material structure according to one embodiment of the present invention;
Figure 1b shows the results of optical reflection data that illustrates benefits of the present invention;
Figure 2 illustrates a material structure according to one embodiment of the present invention; and
Figure 3 illustrates a solar cell according to one embodiment of the present invention;
Figure 4 shows the results of electrical measurements that illustrates benefits of the present invention;

### Detailed description

The present invention will now be described more fully hereinafter with reference to the accompanying drawings, in which currently preferred embodiments of the invention are shown. This invention may, however, be embodied in many different forms and should not be construed as limited to the embodiments set forth herein. These embodiments are rather provided for thoroughness and completeness, and for fully conveying the scope of the invention to the skilled person.

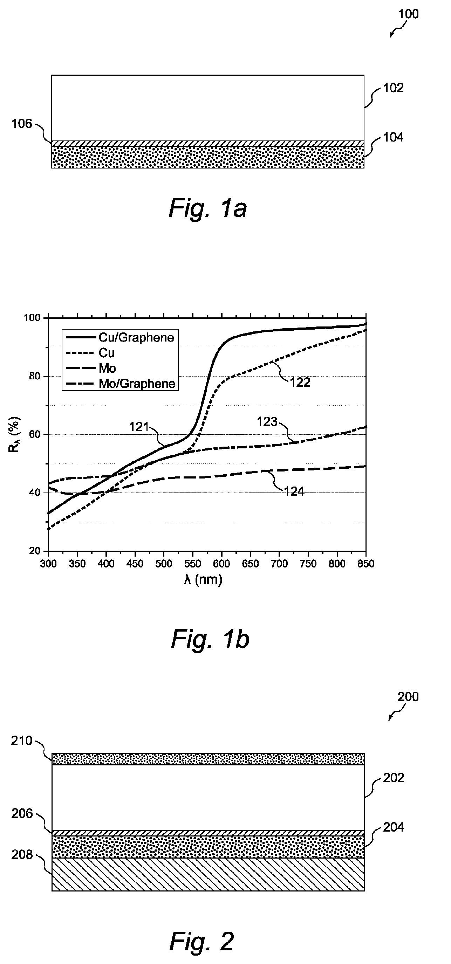

In the following, a material structure for a solar cell will be discussed with reference to figures 1a, 1b and 2. Figure 1 a illustrates a material structure for a solar cell. The material structure 100 comprises a light absorbing layer 102, a metal layer 104 and a graphene layer 106 that is arranged between the light absorbing layer 102 and the metal layer 104 such that the graphene layer 106 forms an electrical interface between the light absorbing layer 102 and the metal layer 104.

The light absorbing layer 102 comprises Cu(In, Ga)Se₂, also referred to as CIGS. The CIGS light absorbing layer 102 has a higher absorption coefficient than e.g. crystalline silicon, and therefore a lower thickness of the light absorbing layer 102 is needed to collect and absorb the same amount of photons as compared to silicon based solar cells.

In figure 1a, the metal layer 104 comprises copper, Cu. The increased reflectivity provided by the Cu metal layer 104, as may be seen in the later discussion relating to figure 1b increase the amount of light on the material structure 100 that may be absorbed by the light absorbing layer 102. The thickness of the light absorbing layer 102 may therefore be further reduced, and thinner and more cost effective solar cells may be provided with respect to solar cells not comprising the material structure 100. In addition, a metal layer 104 comprising Cu further offers improved performance of the material structure 100. Compared with e.g. molybdenum, Mo, the use of Cu may offer improved electrical conductivity, e.g. four times higher, and improved thermal conductivity. The cost of Cu is also lower, e.g. one fourth of the cost, and the use of Cu may allow for a more cost effective manufacturing of the material structure 100 as compared to a metal layer that comprises Mo. In other words, a material structure 100 comprising a lower amount, or none, of Mo may thereby be obtained, and the costs associated with material forming the structure 100 may thereby be reduced.

The graphene layer 106 protects the metal layer 104, e.g. during fabrication and blocks the diffusion of selenium, Se, from the light absorbing layer 102 to the metal layer 104. This prevents the formation of a selenized, e.g. Cu-Se systems, intermediate layer and eliminates the risks of such an intermediate layer becoming too thick or the metal layer being transformed into a semiconductor. Likewise, the graphene layer 106 may prohibit migration of Cu from the metal layer 104 to the absorbing layer 102, a migration which may otherwise reduce the performance of the material structure 100 when used e.g. in a solar cell. A Cu-Se layer that may be present during e.g. growth of the CIGS absorbing layer 102 during fabrication, on top of a Cu metal layer 104 may be problematic also due to lattice mismatch. Such a mismatch may cause the Cu-Se layer to fall off from the underlying Cu metal layer 104. By prohibiting, or at least partly prohibiting, the transfer of Se to the Cu metal layer 104, the graphene layer 106 may also prohibit, or at least partly prohibit, the formation of such a Cu-Se layer.

The graphene layer 106 may not necessarily be a monolayer, i.e. comprising only a single layer of carbon atoms. On the contrary, the graphene layer 106 may be of a bilayer or multilayer type, i.e. comprising two or more layers of carbon atoms arranged in honeycomb-like patterns in each layer, as long as conformal, or at least substantially conformal, coverage between the metal layer 104 and the light absorbing layer 102 is achieved. By not requiring the graphene layer 106 to be a monolayer, the fabrication cost and complexity related to the graphene layer 106 may be reduced. The stacking of the individual layers for bilayer graphene may be of e.g. A-A or A-B (Bernal) type. The stacking of the individual layers for multilayer graphene (e.g. trilayer) may be of e.g. A-A-A, A-B-A, i.e. Bernal type, A-B-C, rhombohedral type, or of other stacking types depending on e.g. the number of carbon atom layers in the multilayer graphene.

The graphene layer 106 is arranged on top of the metal layer 104. The graphene layer may preferably be grown using the Cu metal layer 104 as a native substrate for growth. The graphene layer 106 may thereby be formed directly on top of the metal layer 104. Preferably this is achieved by the use of chemical vapor deposition, CVD, or plasma-enhanced CVD, PE-CVD, but other known and suitable techniques may also be envisaged.

Figure 1b shows the results of optical reflection data illustrating benefits of arranging the graphene layer 106 between the light absorbing layer 102 and the metal layer 104. In the figure, the results of optical reflection data are shown. The reflection, R_{λ}, is shown as a percentage ranging from 0 to 100% for different material structures and for different wavelengths, λ, spanning at least the range of visible light.

For most of the shown wavelengths, it may be seen that a metal layer comprising bare Cu (dashed line 122) has higher optical reflection than a metal layer comprising bare Mo (dashed line 124). As the inventors have realized, adding the graphene layer 106 on top of the metal layer 104 may further increase the optical reflection capabilities of both Cu (solid line 121) and Mo (dashed line 123), as is also shown in the figure. From the measurement results, it is apparent that the combination of Cu with a graphene layer on top (solid line 121) has the highest optical reflection within most of the range of visible light.

Figure 2 illustrates a material structure 200 for a solar cell, in which a substrate 208 and a buffer layer 210 are included.

A typical thickness of the substrate 208 is between 1 - 3 mm, although other thicknesses may also be used.

The metal layer 204 is arranged on the substrate 208. As mentioned above, the metal layer preferably comprises Cu, or alternatively Mo, but the inclusion or use of other metals, which have a high optical reflection and that would otherwise selenize under the growth of e.g. a CIGS absorbing layer, is also envisaged. The metal layer 204 typically has a thickness between 0.5 - 5 µm.

The graphene layer 206 is arranged between the metal layer 204 and the light absorbing layer 202, such that it forms an electrical interface between the latter two layers 202 and 204 and allows current to flow in between.

The light absorbing layer 202 preferably comprises a CIGS compound semiconductor, p-type, and its thickness is typically a few µm, e.g. between 1 - 6 µm.

The buffer layer 210 is deposited on the light absorbing layer 202, and comprises an n-type CdS material. The light absorbing layer 202 and the buffer layer 210 thereby form part of a p-n junction that is arranged to convert light into an electric voltage. Preferably, the buffer layer 210 is not as thick as the light absorbing layer 202, allowing for most of the incoming photons to be absorbed in the light absorbing layer 202. The thickness of the buffer layer 210 is typically only fractions of a µm, e.g. around 0.05 µm, and the buffer layer 210 may be deposited using e.g. a standard chemical bath deposition, CBD, process or any other suitable technique.

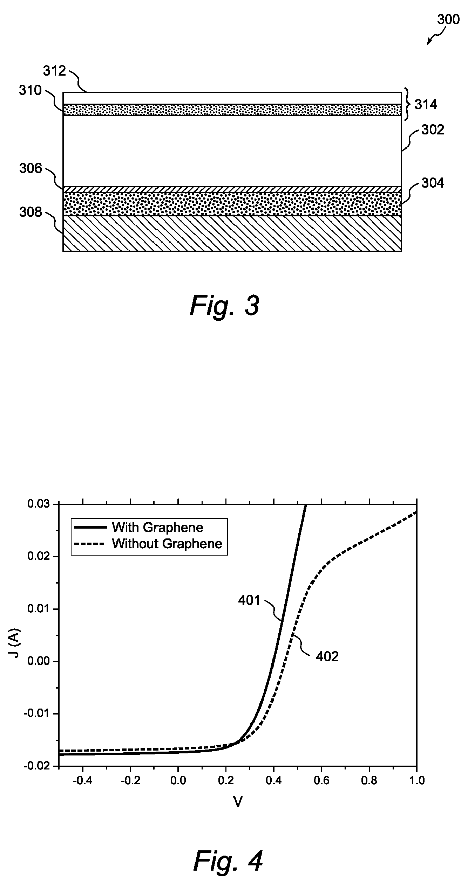

A solar cell comprising a material structure according to any of the above described embodiments will now be discussed with reference to figure 3. Figure 3 illustrates a solar cell 300 in which a material structure comprising a light absorbing layer 302, a metal layer 304 and a graphene layer 306 arranged between the layers 302 and 304 is included. The material structure and/or the solar cell 300 further includes a substrate 308 on which the metal layer 304 is arranged and a buffer layer 310 that forms part of a p-n junction in combination with the light absorbing layer 302.

The buffer layer 310 comprises CdS and further forms part of a stack of layers 314 as illustrated in figure 3. The stack of layers 314 may comprise a transparent conducting layer 312 arranged on top of the buffer layer 310. The transparent conducting layer 312 comprises, in the depicted embodiment, an i-ZnO/ZnO:Al material, i.e. a thin, intrinsic zinc oxide layer, i-ZnO, which is capped by a thicker, aluminium, Al, doped ZnO layer. The i-ZnO layer is used to protect the CdS buffer layer and the light absorbing layer 302 from sputtering damage while depositing the ZnO:Al layer. The Al doped ZnO serves as a transparent conducting oxide that is used to collect and move electrons out of the solar cell 300 while absorbing as little light as possible.

The solar cell 300 comprises a heterostructure junction formed between the CIGS light absorbing layer 302 and the transparent conducting layer 312 of ZnO, which are separated by the thin buffer layer 310 of CdS and a layer of intrinsic ZnO. The CIGS light absorbing layer 302 is doped p-type by intrinsic defects, while the ZnO transparent conducting layer 312 is doped n-type to a much larger extent through the incorporation of Al. This asymmetric doping provides a space-charge region that to a larger extent extends into the CIGS than into the ZnO. The absorption of light is thereby designed to predominantly occur in the light absorbing layer 302 than in e.g. the buffer layer 310. To this end, the thicknesses and band gaps of the light absorbing layer 302, the buffer layer 310 and the transparent conducting layer 312 are chosen such that the light is absorbed predominantly in the light absorbing layer 302. The band gap of the CIGS light absorbing layer 302 typically ranges between 1.02 eV for CuInSe₂ to 1.65 for CuGaSe₂ providing increased light absorption, while the larger band gaps for ZnO at 3.2 eV and CdS at 2.4 eV minimizes light absorption in the upper layers 310 and 312 that forms part of the stack of layers 314. The doped ZnO also serves as a front contact for the current collection. The transparent conducting layer 312 may be formed using e.g. a shunt reducing intrinsic ZnO layer, i-ZnO, followed by subsequent sputtering of Al-doped ZnO, ZnO:Al.

The stack of layers 314 may further comprise, not shown, e.g. an anti-reflective coating which may be formed by evaporation to improve light absorption of the solar cell, mainly by avoiding interference effects. In addition, a front contact grid comprising e.g. a nickel/aluminium/nickel, Ni/Al/Ni stack, not shown, may further be deposited by e.g. evaporation.

In the embodiments, as described above or others, the buffer layer 210, 310 may alternatively comprise a material selected from the group consisting of Zn₁₋ₓSnₓO_{y}, In₂S₃, Zn(S,O,OH), Zn(S,O), InSₓO_{y,} ZnS, ZnS:In₂S₃ and InₓS_{y}

The transparent conductive layer 312 may, moreover, comprise a material selected from the group consisting of Ga-doped ZnO, SnO₂:In₂O₃, SnO₂:F, CdO:ln, graphene and carbon nano-tubes.

According to the above description, the metal layer 104, 204, 304 has preferably been described as comprising Cu. It has also been envisaged that the metal layer 104, 204, 304 comprises Mo. To this end, figure 4 illustrates current as a function of voltage for two solar cell structures both comprising a CIGS light absorbing layer on top of a contact metal layer made of Mo. The first structure, solid line 401, further comprises a graphene layer that forms an electrical interface between the light absorbing layer and the metal layer, and thus implements a material structure for a solar cell in accordance with the present inventive concept described herewithin. More specifically, the graphene layer is arranged on top of the metal layer made of Mo. The second structure, dashed line 402, is a reference structure that has no such graphene layer. From figure 4 it may be deduced that the graphene layer may improve the electrical contact of the metal layer and that a material structure according to the present inventive concept may be beneficial.

It is envisaged that the metal layer 104, 204, 304 also may comprise Al, Ag, Au, W, Cr, Ta, Nb, V, Ti, Mn, ZrN, TiN, Nb:TiO₂, TiB₂ or combinations thereof. It is, however, preferable to use at least Cu or Mo as these metals e.g. also may serve as a catalyst and/or native substrate for growing the graphene layer 106, 206, 306.

The light absorbing layer 102, 202, 302 has been described as preferably comprising CIGS. The light absorbing layer 102, 202, 302 may alternatively comprise another compound semiconductor material such as Cu(In, Ga)(S, Se)₂, Cu₂ZnSn(S, Se)₄ or CdTe.

The person skilled in the art further realizes that the present invention by no means is limited to the preferred embodiments as described above. On the contrary, many modifications and variations are possible within the scope of the appended claims. For example, the substrate 208, 308 may be a glass material such as soda-lime glass, alkali-aluminosilicate glass, boro-silicate glass or quartz, depending on e.g. the preferred process of growing the graphene layer. The substrate 208, 308 may alternatively comprise steel, a metal-foil of e.g. aluminium, a polymer, a plastic or a ceramic.

The light absorbing layer 102, 202, 302 may comprise a III-V or a II-VI semiconductor material. Hence, the light absorbing layer 102, 202, 302 may in some embodiments for example comprise GaAs and/or InP and/or Si. The light absorbing layer 102, 202, 302 may be of a material having a perovskite crystal structure, and/or be formed by a chalcopyrite or a kesterite material. For such materials, the substrate may be a sheet of glass or foil. The glass substrate may for example have a dimension of 80 cm x 120 cm. The foil may typically be arranged in a roll of a specific width, which may be 1 m in extension.

The substrate 208, 308 may form the metal layer 104, 204, 304 and vice versa.

In addition, variations to the disclosed embodiments may be understood and effected by the skilled person in practicing the claimed invention from a study of the drawings, the disclosure and/or the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to an advantage.

## Claims

1. A material structure (100) for a solar cell, the material structure comprising,
a light absorbing layer (102, 202, 302),
a metal layer (104, 204, 304),
a graphene layer (106, 206, 306) arranged in between the light absorbing layer and the metal layer,
such that the graphene layer forms an electrical interface between the light absorbing layer and the metal layer,
wherein the metal layer comprises at least one of Cu and Mo.

2. The material structure according to claim 1, wherein the light absorbing layer comprises a compound semiconductor material selected from the group of Cu(In, Ga)Se₂, Cu(In, Ga)(S, Se)₂, Cu₂ZnSn(S, Se)₄, and CdTe.

3. The material structure according to claim 1 or 2, further comprising a substrate (208, 308), wherein the metal layer is arranged on the substrate.

4. The material structure according to claim 3, wherein the substrate comprises at least one of glass, steel, metal foil, and a polymer.

5. The material structure according to any one of claims 1 to 4, further comprising a buffer layer (210, 310), the buffer layer and the light absorbing layer forming parts of a p-n junction arranged to convert light into an electric voltage.

6. The material structure according to claim 5, wherein the buffer layer comprises at least one of CdS, Zn(O, S), In₂S₃, (Zn, Sn)O_{y,}and (Zn, Mg)O.

7. The material structure according to any one of claims 1 to 6, wherein the graphene layer is a bilayer or multilayer graphene layer.

8. The material structure according to any one of claims 1 to 7, wherein the graphene layer is disposed on top of the metal layer.

9. A solar cell (300) comprising a material structure according to any one of claims 1 to 8.

10. The solar cell according to claim 9, wherein said solar cell is a thin-film solar cell.
